# EUROPEAN PATENT SPECIFICATION

(11) **EP 1 354 351 B1**
(45) Date of publication and mention of the grant of the patent: **15.04.2009**
(21) Application number: 01962043.4
(22) Date of filing: 10.08.2001
(51) Int. Cl.: H01L 23/31, H01L 21/56, H01L 21/60, H01L 23/538

(54) **DIRECT BUILD-UP LAYER ON AN ENCAPSULATED DIE PACKAGE**
DIREKTAUFBAUSCHICHT AUF EINER VERKAPSELTEN CHIPVERPACKUNG
COUCHE FORMEE DIRECTEMENT SUR UN BOITIER A PUCE ENCAPSULE

(30) Priority: 16.08.2000 US 640961
(43) Date of publication of application: 22.10.2003
(73) Proprietor: Intel Corporation, Santa Clara, CA 95052 (US)
(72) Inventor: MU, Xiao-Chun, Saratoga, CA 95070 (US); MA, Qing, San Jose, CA 95129 (US); FUJIMOTO, Harry, Synnyvale, CA 94087 (US)
(74) Representative: Collins, John David
(86) International application number: PCT/US2001/025060
(87) International publication number: WO 2002/015266

(56) References cited:
- EP-A- 0 611 129
- EP-A- 0 707 340
- US-A- 5 048 179
- US-A- 5 291 066

## Description

The present invention relates to apparatus and processes for packaging microelectronic dice. In particular, the present invention relates to a packaging technology that fabricates build-up layers on encapsulated microelectronic dice and on the encapsulation material which covers the microelectronic dice.

Higher performance, lower cost, increased miniaturization of integrated circuit components, and greater packaging density of integrated circuits are ongoing goals of the computer industry. As these goals are achieved, microelectronic dice become smaller. Of course, the goal of greater packaging density requires that the entire microelectronic die package be equal to or only slightly larger (about 10% to 30%) than the size of the microelectronic die itself. Such microelectronic die packaging is called a "chip scale packaging" or "CSP".

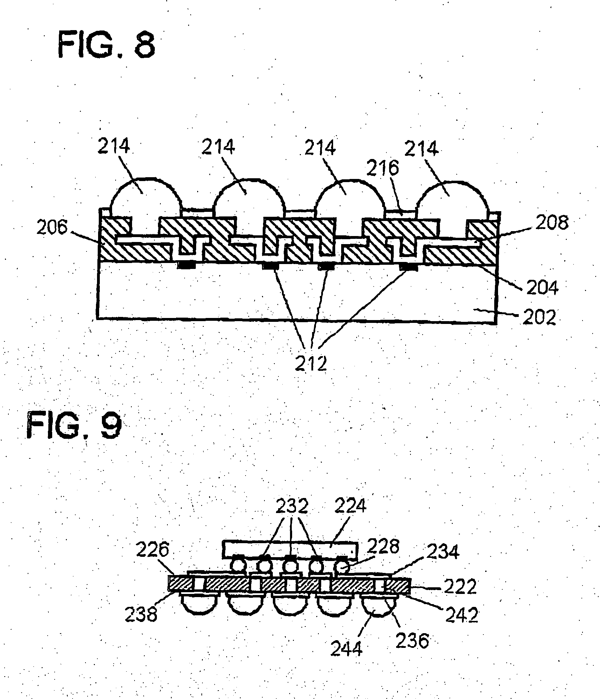

As shown in FIG. 8, which does not comprise prior art, a hypothetical true CSP could involve fabricating build-up layers directly on an active surface 204 of a microelectronic die 202. The build-up layers may include a dielectric layer 206 disposed on the microelectronic die active surface 204. Conductive traces 208 may be formed on the dielectric layer 206, wherein a portion of each conductive trace 208 contacts at least one contact 212 on the microelectronic die active surface 204. External contacts, such as solder balls or conductive pins for contact with an external component (not shown), may be fabricated to electrically contact at least one conductive trace 208. FIG. 8 illustrates the external contacts as solder balls 214 which are surrounded by a solder mask material 216 on the dielectric layer 206. However in such true CSP, the surface area provided by the microelectronic die active surface 204 generally does not provide enough surface for all of the external contacts needed to contact the external component (not shown) for certain types of microelectronic dice (i.e., logic).

Additional surface area can be provided through the use of an interposer, such as a substrate (substantially rigid material) or a flex component (substantially flexible material). FIG. 9 illustrates a substrate interposer 222 having a microelectronic die 224 attached to and in electrical contact with a first surface 226 of the substrate interposer 222 through small solder balls 228. The small solder balls 228 extend between contacts 232 on the microelectronic die 224 and conductive traces 234 on the substrate interposer first surface 226. The conductive traces 234 are in discrete electrical contact with bond pads 236 on a second surface 238 of the substrate interposer 222 through vias 242 that extend through the substrate interposer 222. External contacts 244 (shown as solder balls) are formed on the bond pads 236. The external contacts 244 are utilized to achieve electrical communication between the microelectronic die 224 and an external electrical system (not shown).

The use of the substrate interposer 222 requires number of processing steps. These processing steps increase the cost of the package. Additionally, even the use of the small solder balls 228 presents crowding problems which can result in shorting between the small solder balls 228 and can present difficulties in inserting underfilling between the microelectronic die 224 and the substrate interposer 222 to prevent contamination and provide mechanical stability.

Therefore, it would be advantageous to develop new apparatus and techniques to provide additional surface area to form traces for use in CSP applications, while utilizing commercially available, widely practiced semiconductor fabrication techniques.

EP0611129 discloses an embedded substrate for integrated circuit modules. Chips having contact pads are placed face down on a layer of adhesive supported by a base. A mold form is positioned around the chips. Substrate molding material is added within the mold form, and the substrate molding material is then hardened. A dielectric layer having vias aligned with predetermined ones of the contact pads and having an electrical conductor extending through the vias is situated on the hardened substrate molding material and the faces of the chips. A connector frame may be placed on the adhesive layer before substrate molding material is added. A dielectric layer may be placed over the backsides of the chips before the substrate molding material is added to enhance repairability. A portion of the chips and substrate molding material may be removed after the substrate molding material is hardened.

The present invention is defined in appended Claims 1, 4 and 9.

Embodiments of the present invention will now be described with preference to the accompanying drawings, in which:
FIGs. 1a-1j are side cross-sectional views of a first embodiment of a process of forming a microelectronic package, according to the present invention;
FIGs. 2a-2d are side cross-sectional views of another embodiment of a process of forming a microelectronic package that incorporates a heat dissipation device, according to the present invention;
FIGs. 3a-3f are side cross-sectional views of a method for die alignment, attachment, and molding of a microelectronic package, according to one embodiment of the present invention;
FIGs. 4a-4e are side cross-sectional views of another method for die alignment, attachment, and molding of a microelectronic package, according to one embodiment of the present invention;
FIGs. 5a-5f are side cross-sectional views of still another method for die alignment, attachment, and molding of a microelectronic package, according to one embodiment of the present invention;
FIGs. 6a-6e are side cross-sectional views of an alternate method for die alignment, attachment, and molding of microelectronic package, according to one embodiment of the present invention;
FIGs. 7a-7e are side cross-sectional views of another alternate method for die alignment, attachment, and molding of a microelectronic package, according to one embodiment not part of the present invention;
FIG. 8 is a cross-sectional view of hypothetical true CSP of a microelectronic device; and
FIG. 9 is a cross-sectional view of a hypothetical CSP of a microelectronic device utilizing a substrate interposer.

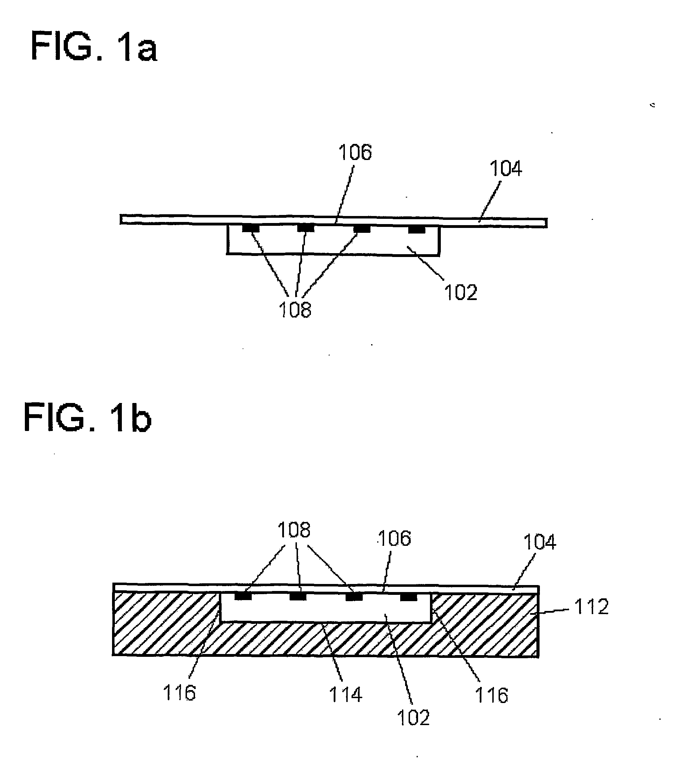

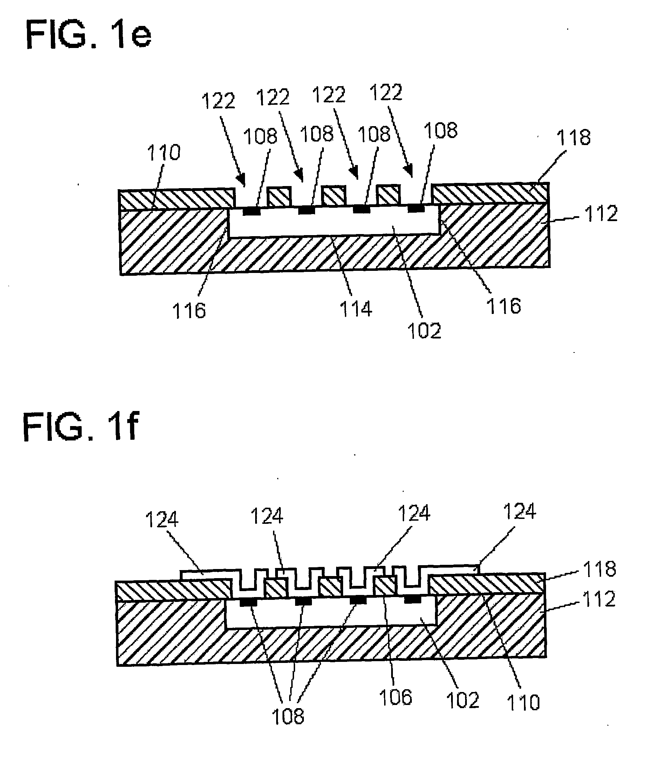

Although FIGs. 1a-1j, 2a-2d, 3a-3f, 4a-4e, 5a-5f, 6a-6e, and 7a-7e illustrate various views of embodiments of the present invention, these figures are not meant to portray microelectronic assemblies in precise detail. Rather, these figures illustrate semiconductor assemblies in a manner to more clearly convey the concepts of the present invention. Additionally, elements common between the figures retain the same numeric designation.

Embodiments of the present invention relate to a packaging technology that fabricated build-up layers on an encapsulated microelectronic die and on the encapsulation material that covers the microelectronic die. An exemplary microelectronic package includes a microelectronic die having an active surface and at least one side. An encapsulation material is disposed adjacent the microelectronic die side(s), wherein the encapsulation material includes at least one surface substantially planar to the microelectronic die active surface. A first dielectric material layer may be disposed on at least a portion of the microelectronic die active surface and the encapsulation material surface. At least one conductive trace is then disposed on the first dielectric material layer. The conductive trace(s) is in electrical contact with the microelectronic die active surface. At least one conductive trace extends adjacent the microelectronic die active surface and adjacent the encapsulation material surface.

FIGs. 1a-1j illustrate a first embodiment of a process of forming a microelectronic package of the present invention. As shown in FIG. 1a, a protective film 104 is abutted against an active surface 106 of a microelectronic die 102 to protect the microelectronic die active surface 106 from any contaminants. The microelectronic die active surface 106 has at least one contact 108 disposed thereon. The contacts 108 are in electrical contact with integrated circuitry (not shown) within the microelectronic die 102. The protective film 104 is preferably a polyimide material and may have a weak adhesive, such as silicone, which attaches to the microelectronic die active surface 106. This adhesive-type film may be applied prior to placing the microelectronic die 102 in a mold or other such equipment used for the encapsulation process. The protective film 104 may also be a non-adhesive film, such as a ETFE (ethylene - tetrafluoroethylene) or Teflon^{®} film, which is held on the microelectronic die active surface 106 by an inner surface of the mold or other such equipment during the encapsulation process.

The microelectronic die 102 is then encapsulated with an encapsulating material 112, such as plastics, resins, epoxies, and the like, as shown in FIG. 1b, that covers a back surface 114 and side(s) 116 of the microelectronic die 102. The encapsulation of the microelectronic die 102 may be achieved by any known process, including but not limited to transfer and compression molding, and dispensing. The encapsulation material 112 provides mechanical rigidity, protects the microelectronic die 102 from contaminants, and provides surface area for the build-up of trace layers.

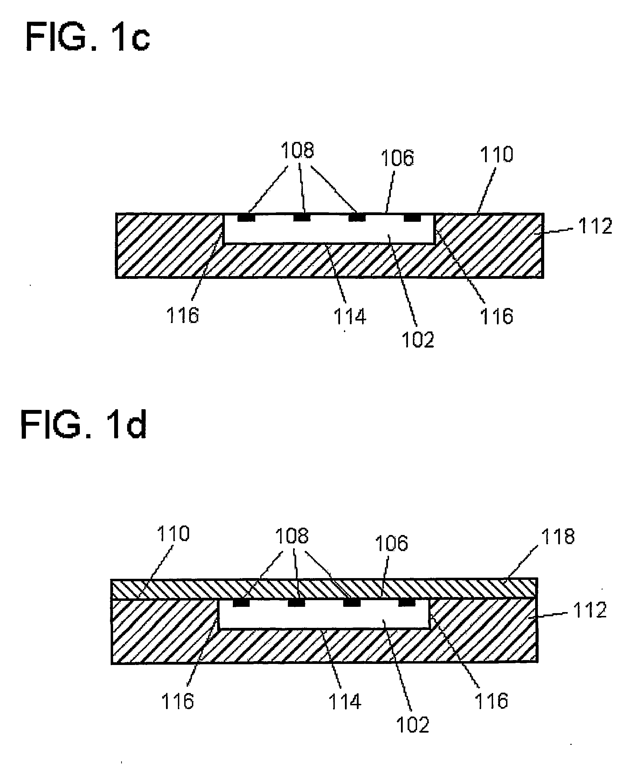

After encapsulation, the protective film 104 is removed, as shown in FIG. 1c, to expose the microelectronic die active surface 106. As also shown in FIG. 1c, the encapsulation material 112 is preferably molded to form at least one surface 110 which is substantially planar to the microelectronic die active surface 106. The encapsulation material surface 110 will be utilized in further fabrication steps as additional surface area for the formation of build-up layers, such as dielectric material layers and conductive traces.

A first dielectric layer 118, such as epoxy resin, polyimide, bisbenzocyclobutene, and the like, is disposed over the microelectronic die active surface 106, the contacts 108, and the encapsulation material surface 110, as shown in FIG. 1d. The dielectric layers of one embodiment of the present invention are preferably filled epoxy resins available from Ibiden U.S.A. Corp., Santa, Clara, California, U.S.A. and Ajinomoto U.S.A., Inc., Paramus, New Jersey, U.S.A. The formation of the first dielectric layer 118 may be achieved by any known process, including but not limited to film lamination, spin coating, roll-coating and spray-on deposition.

As shown in FIG. le, a plurality of vias 122 are then formed through the first dielectric layer 118. The plurality of vias 122 may be formed any method known in the art, including but not limited to laser drilling, photolithography, and, if the first dielectric layer 118 is photoactive, forming the plurality of vias 122 in the same manner that a photoresist mask is made in a photolithographic process, as known in the art.

A plurality of conductive traces 124 is formed on the first dielectric layer 118, as shown in FIG. 1f, wherein a portion of each of the plurality of conductive traces 124 extends into at least one of said plurality of vias 122 to make electrical contact with the contacts 108. The plurality of conductive traces 124 may be made of any applicable conductive material, such as copper, aluminum, and alloys thereof. As shown in FIG. 1f at least one conductive trace extends adjacent the microelectronic die active surface 106 and adjacent said encapsulation material surface 110.

The plurality of conductive traces 124 may be formed by any known technique, including but not limited to semi-additive plating and photolithographic techniques. An exemplary semi-additive plating technique can involve depositing a seed layer, such as sputter-deposited or electroless-deposited metal on the.first dielectric layer 118. A resist layer is then patterned on the seed layer, such as a titanium/copper alloy, followed by electrolytic plating of a layer of metal, such as copper, on the seed layer exposed by open areas in the patterned resist layer. The patterned resist layer is stripped and portions of the seed layer not having the layer of metal plated thereon is etched away. Other methods of forming the plurality of conductive traces 124 will be apparent to those skilled in the art.

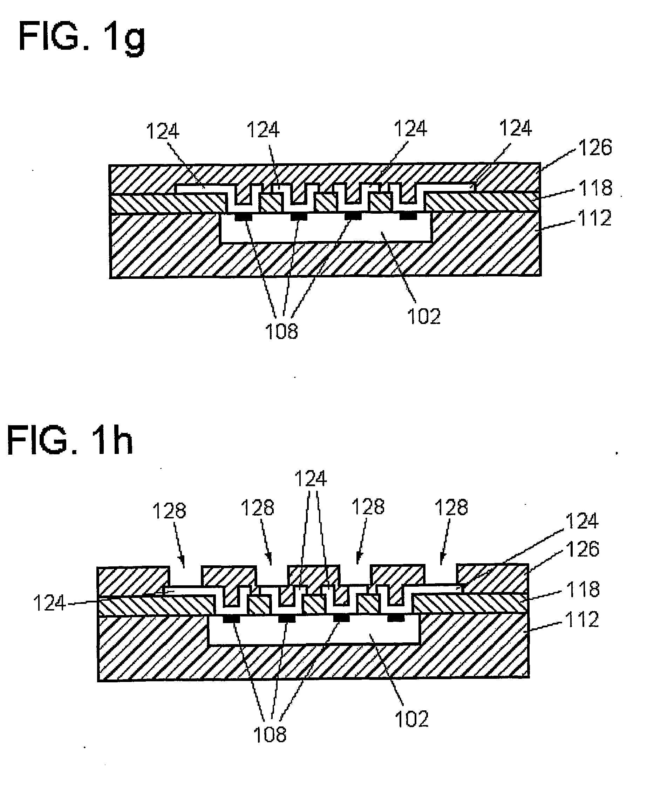

As shown in FIG. 1g, a second dielectric layer 126 is disposed over the plurality of conductive traces 124 and the first dielectric layer 118. The formation of the second dielectric layer 126 may be achieved by any known process, including but not limited to film lamination, roll-coating and spray-on deposition.

As shown in FIG. 1h, a plurality of second vias 128 are then formed through the second dielectric layer 126. The plurality of second vias 128 may be formed any method known in the art, including but not limited to laser drilling and, if the second dielectric layer 126 is photoactive, forming the plurality of second vias 128 in the same manner that a photoresist mask is made in a photolithographic process, as known in the art.

If the plurality of conductive traces 124 is not capable of placing the plurality of second vias 128 in an appropriate position, then other portions of the conductive traces are formed in the plurality of second vias 128 and on the second dielectric layer 126, another dielectric layer formed thereon, and another plurality of vias is formed in the dielectric layer, such as described in FIG. 1f-1h. The layering of dielectric layers and the formation of conductive traces can be repeated until the vias are in an appropriate position. Thus, portions of a single conductive trace be formed from multiple portions thereof and can reside on different dielectric layers.

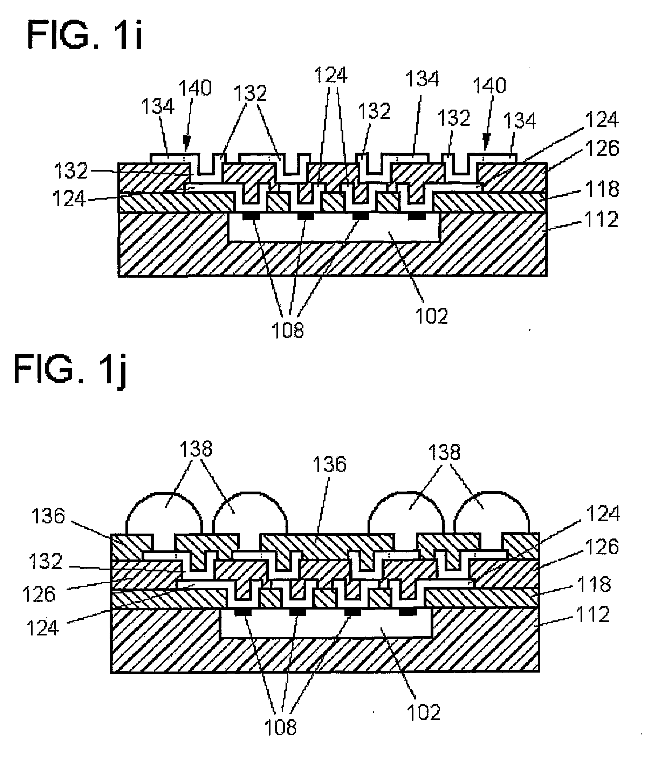

A second plurality of conductive traces 132 may be formed, wherein a portion of each of the second plurality of conductive traces 132 extends into at least one of said plurality of second vias 128. The second plurality of conductive traces 132 each include a landing pad 134 (an enlarged area on the traces demarcated by a dashed line 140), as shown in FIG. 1i.

Once the second plurality of conductive traces 132 and landing pads 134 are formed, they can be used in the formation of conductive interconnects, such as solder bumps, solder balls, pins, and the like, for communication with external components (not shown). For example, a solder mask material 136 can be disposed over the second dielectric layer 126 and the second plurality of conductive traces 132 and landing pads 134. A plurality of vias is then formed in the solder mask material 136 to expose at least a portion of each of the landing pads 134. A plurality of conductive bumps 138, such as solder bumps, can be formed, such as by screen printing solder paste followed by a reflow process or by known plating techniques, on the exposed portion of each of the landing pads 134, as shown in FIG 1j.

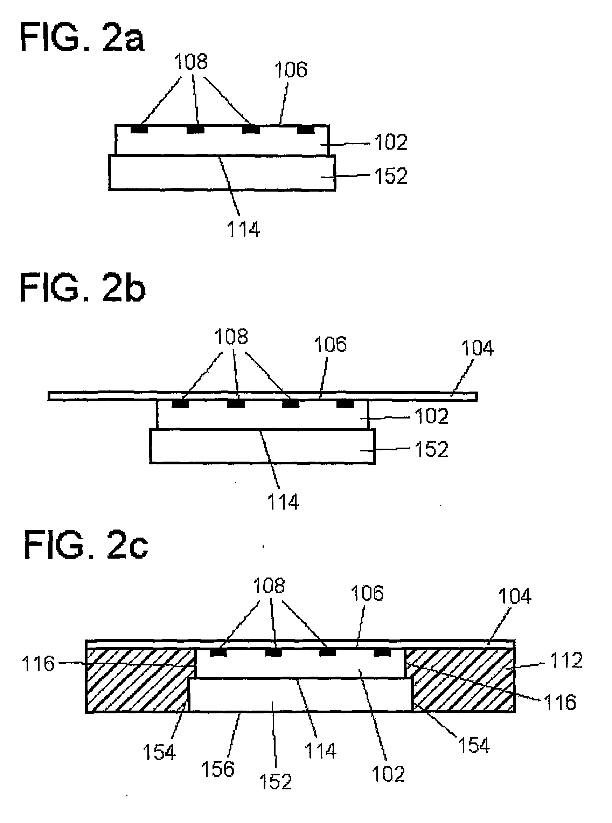

FIGs. 2a-2d illustrate another embodiment of the present invention that incorporates a heat dissipation device. As shown in FIG. 2a, a thermally conductive, heat dissipation device, such as heat slug 152 is attached to the microelectronic die back surface 114, preferably with a thermally conductive adhesive (not shown). The heat slug 152 should have a CTE (coefficient of thermal expansion) close to that of the microelectronic die 102 to reduce thermal stresses. For example, for a microelectronic die 102 formed of a silicon material, thermally conductive materials such as molybdenum and aluminum/silicon/carbon alloys would closely match the CTE of the silicon material.

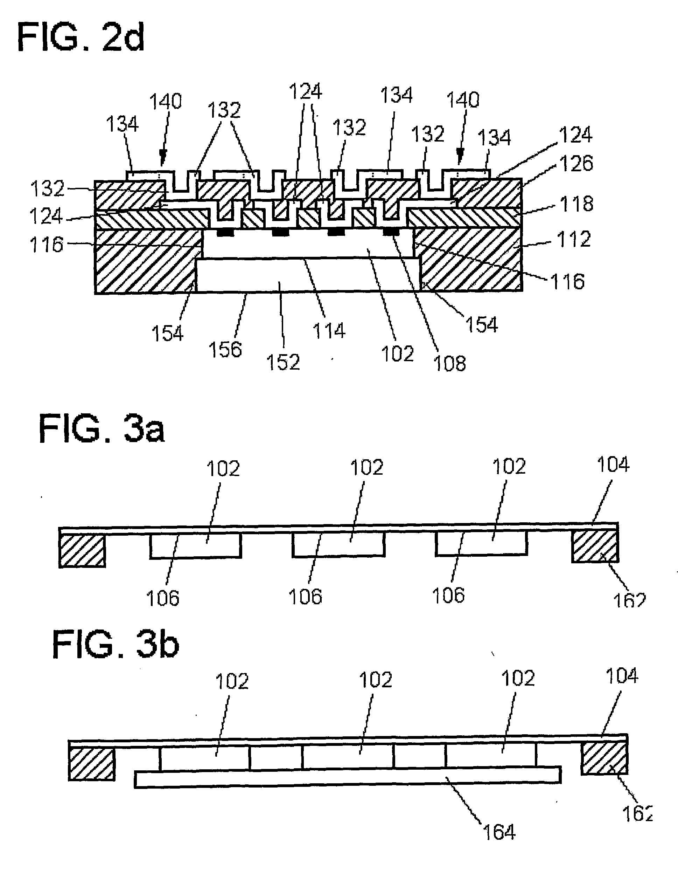

The protective film 104 is abutted against the microelectronic die active surface 106, as shown in FIG. 2b. The protective film 104 may be adhesive or non-adhesive as previously discussed. The microelectronic die 102 and the heat slug 152 are then encapsulated with an encapsulating material 112, as shown in FIG. 2c, that covers microelectronic die side(s) 116 and side(s) 154 of the heat slug 152. A back surface 156 of the heat slug 152 is preferably not cover with the encapsulating material 112 so that thermal energy drawn into the heat slug 152 from the microelectronic die 102 can be dissipated to the ambient environment from the heat slug back surface 156, or so that an addition heat dissipation device can be attached to the heat slug back surface 156. As illustrated in FIG. 2d, after encapsulation, the protective film 104 is removed and at least one dielectric layer (shown as a first dielectric layer 118 and a second dielectric layer 126), conductive traces 124, and landing pads 134 are fabricated, such as described in FIGs. 1c-1i.

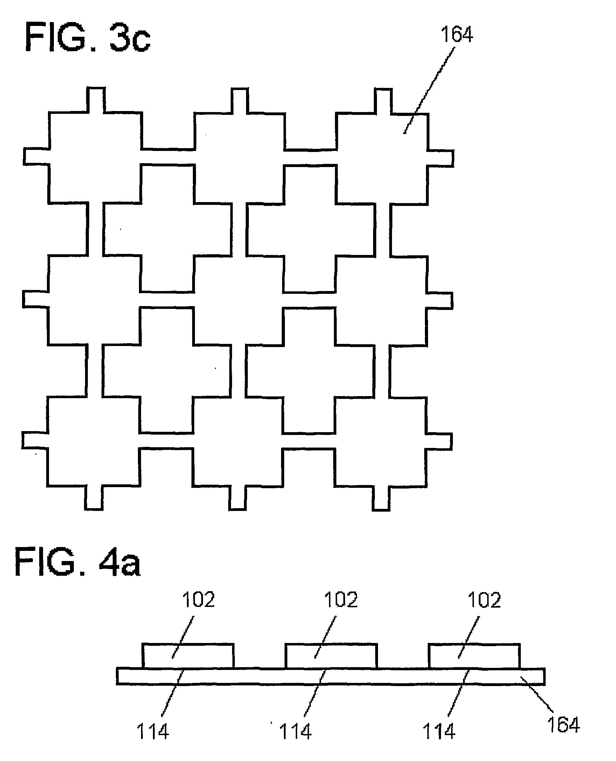

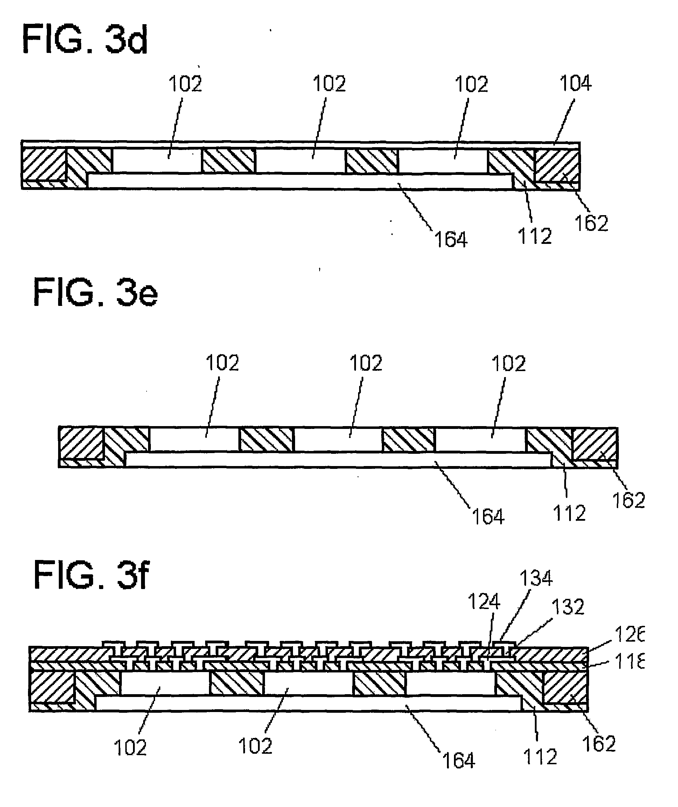

The present invention also includes a methods for die alignment, attachment, and molding. FIGs 3a-3f illustrate one such method. The active surfaces 106 of a plurality of microelectronic dice 102 are aligned on and attached to the protective film 104, preferably an adhesive backed foil, which extends between a rigid frame 162, preferably a metal frame, as shown in FIG. 3a. The alignment of the plurality of microelectronic dice 102 may be achieved with fiducial marks (not shown) on the protective film 104. As shown in FIG. 3b, a thermally conductive, heat dissipation device, such as heat slug 164, is then attached with a thermally conductive adhesive to the plurality of microelectronic dice 102. The heat slug 164 may be a solid plate or may have a webbed configuration, as shown in top view in FIG. 3c. After attachment of the heat slug 164 to the plurality of microelectronic dice 102, the encapsulation material 112 is molded around the microelectronic dice 102 and the heat slug 164, as shown in FIG. 3d. After encapsulation, as shown in FIG. 3e, the protective film 104 is removed to expose the active surfaces 106 of the plurality of microelectronic dice 102. As illustrated in FIG. 3e, at least one dielectric layer (shown as a first dielectric layer 118 and a second dielectric layer 126), conductive traces 124 and 132, and landing pads 134 are fabricated, such as described in FIGs. 1c-1i. It is, of course, understood that the plurality of microelectronic dice 102 and its associated portion of the heat slug 164 could be singulated either before or after the fabrication of the various dielectric layers, conductive traces, and conductive pads.

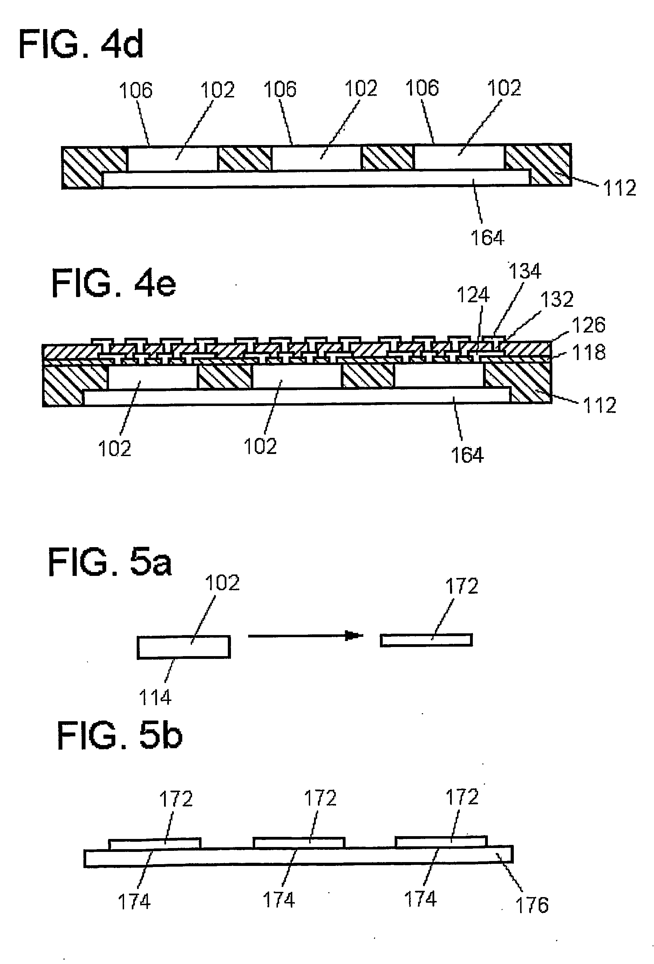

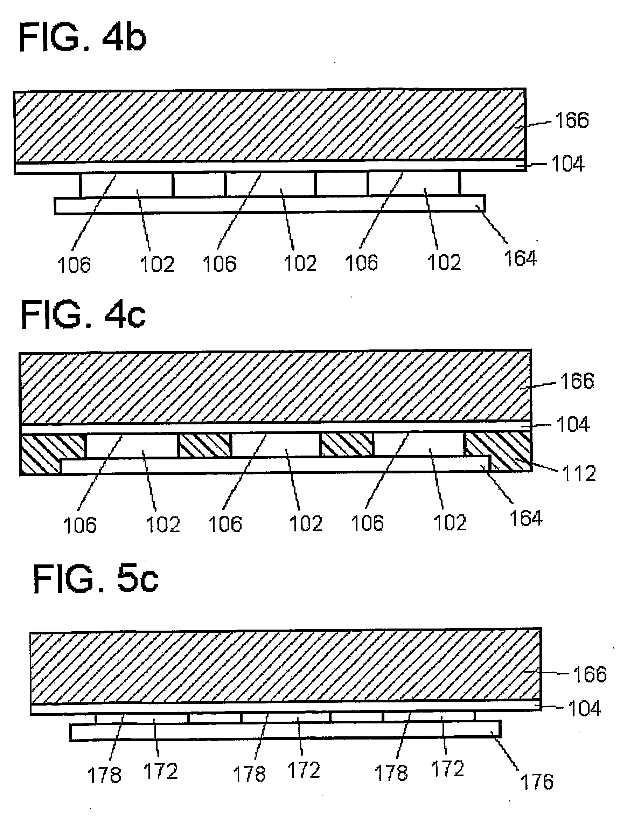

FIGs. 4a-4e illustrate another method for die alignment, attachment, and molding. As shown in FIG. 4a, the back surfaces 114 of a plurality of microelectronic dice 102 are aligned and attached with a thermally conductive adhesive to the heat slug 164. Again, the heat slug 164 may be a solid plate or may have a webbed configuration, as shown in top view in FIG. 3c. The alignment of the plurality of microelectronic dice 102 may be achieved with fiducial marks (not shown) on the heat slug 164. A protective film 104, such as a non-adhesive material, is mounted to a flat plate 166, such as an internal surface of a mold. The protective film 104 is then pressed against the active surfaces 106 of a plurality of microelectronic dice 102, as shown in FIG. 4b. The encapsulation material 112 is molded around the microelectronic dice 102 and the heat slug 164, as shown in FIG. 4c. After encapsulation, as shown in FIG. 4d, the removal of the flat plate 166 also removes the protective film 104 to expose the active surfaces 106 of the plurality of microelectronic dice 102. As illustrated in FIG. 4e, at least one dielectric layer (shown as a first dielectric layer 118 and a second dielectric layer 126), conductive traces 124 and 132, and landing pads 134 are fabricated, such as described in FIGs. 1c-1i. Again, it is understood that the plurality of microelectronic dice 102 and its associated portion of the heat slug 164 could be singulated either before or after the fabrication of the various dielectric layers, conductive traces, and conductive pads.

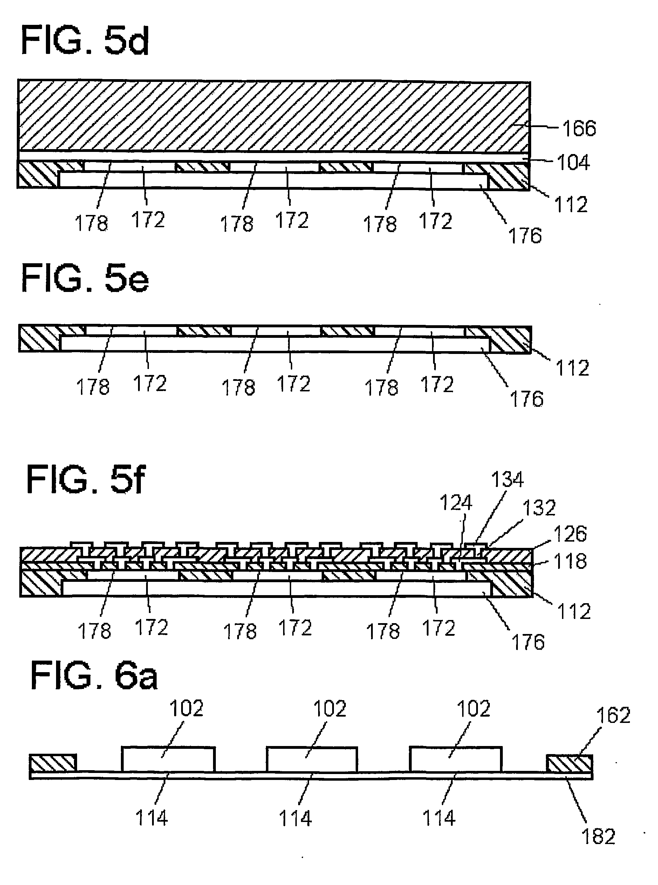

FIGs. 5a-5f illustrate still another method for die alignment, attachment, and molding. As shown in FIG. 5a, the microelectronic die back surface 114 is thinned, such as by grinding, to form a thin microelectronic die 172. The back surfaces 174 of a plurality of thin microelectronic dice 172 are aligned and attached with a thermally conductive adhesive (not shown) to a silicon wafer 176 which acts as heat dissipation device, as shown in FIG. 5b. The alignment of the plurality of thin microelectronic dice 172 may be achieved with fiducial marks (not shown) on the silicon wafer 176. A protective film 104, such as a non-adhesive material, is mounted to a flat plate 166, such as an internal surface of a mold. The protective film 104 is then pressed against the active surfaces 178 of the plurality of microelectronic dice 172, as shown in FIG. 5c. Encapsulation material 112 is molded around the thin microelectronic dice 172 and the silicon wafer 176, as shown in FIG. 5d. After encapsulation, as shown in FIG. 5e, the removal of the flat plate 166 also removes the protective film 104 to expose the active surfaces 178 of the plurality of thin microelectronic dice 172. As illustrated in FIG. 5f, at least one dielectric layer (shown as a first dielectric layer 118 and a second dielectric layer 126), conductive traces 124 and 132, and landing pads 134 are fabricated, such as described in FIGs. 1c-1i. Again, it is understood that the plurality of thin microelectronic dice 172 and its associated portion of the silicon wafer 176 could be singulated either before or after the fabrication of the various dielectric layers, conductive traces, and conductive pads.

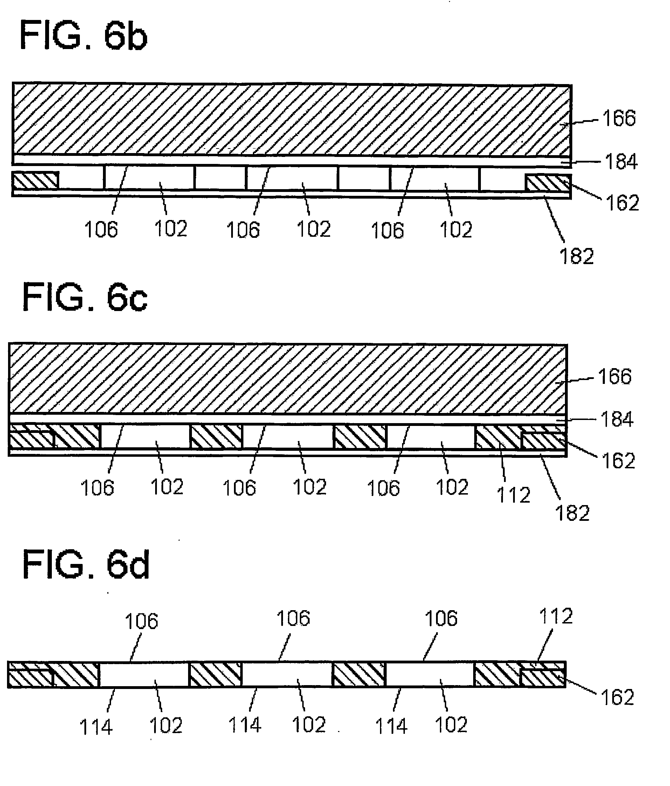

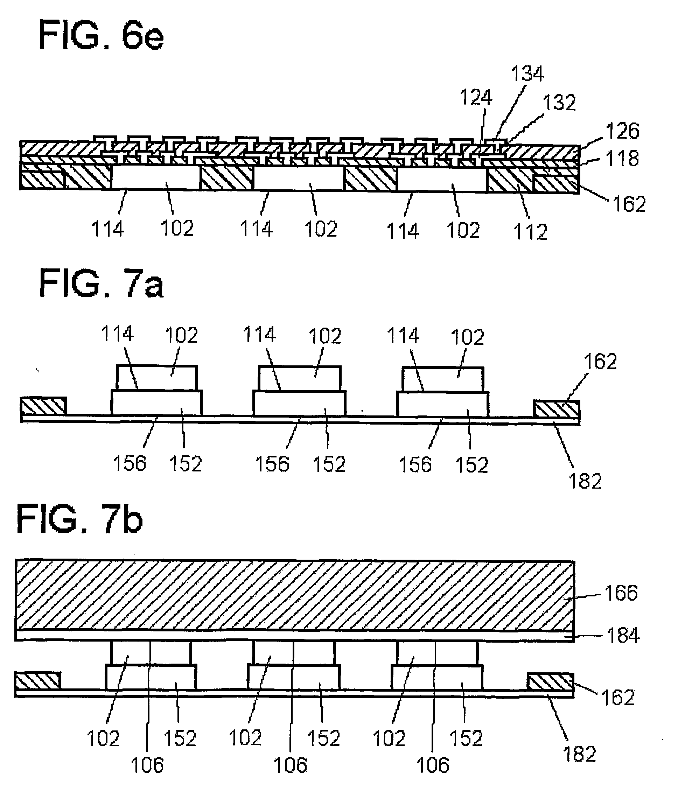

FIGs. 6a-6e illustrate still another method for die alignment, attachment, and molding. As shown in FIG. 6a, the back surfaces 114 of a plurality of microelectronic dice 102 are aligned on and attached to a first protective film 182, preferably an adhesive backed foil, which extends between a rigid frame 162, preferably a metal frame, as shown in FIG. 3a. The alignment of the plurality of microelectronic dice 102 may be achieved with fiducial marks (not shown) on the first protective film 182. A second protective film 184, such as a non-adhesive material, is mounted to a flat plate 166, such as an internal surface of a mold. The second protective film 184 is then pressed against the active surfaces 106 of a plurality of microelectronic dice 102, as shown in FIG. 6b. The encapsulation material 112 is molded around the microelectronic dice 102, as shown in FIG. 6c. After encapsulation, as shown in FIG. 6d, the removal of the flat plate 166 also removes the second protective film 184 to expose the active surfaces 106 of the plurality of microelectronic dice 102. As illustrated in FIG. 6e, at least one dielectric layer (shown as a first dielectric layer 118 and a second dielectric layer 126), conductive traces 124 and 132, and landing pads 134 are fabricated, such as described in FIGs. 1c-1i. Furthermore, as also shown in FIG. 6d, the first protective film 182 is removed to expose the microelectronic die back surfaces 114. The exposed microelectronic die back surfaces 114 may then be attached to heat dissipation devices. Again, it is understood that the plurality of microelectronic dice 102 could be singulated either before or after the fabrication of the various dielectric layers, conductive traces, and conductive pads.

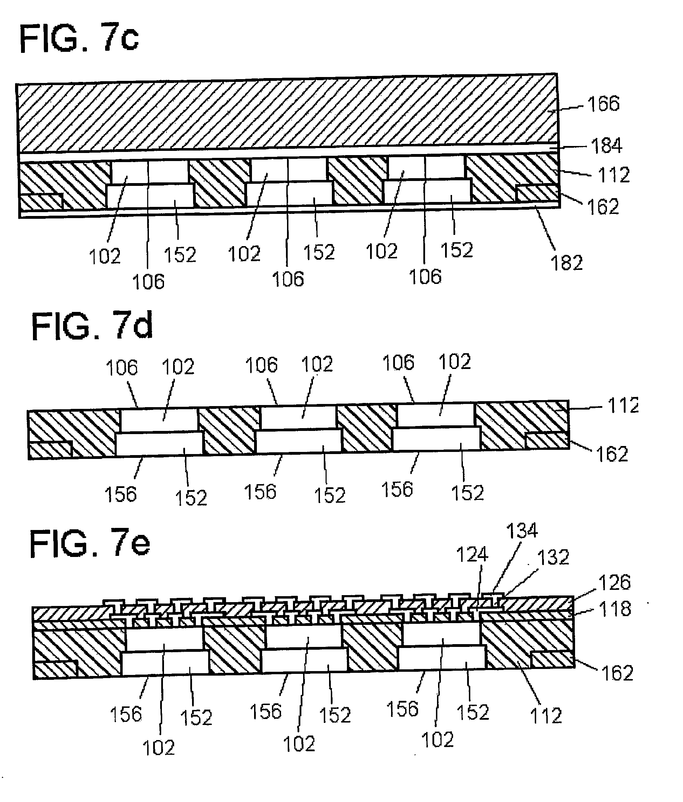

FIGs. 7a-7e illustrate still yet another method for die alignment, attachment, and molding not part of the invention. As shown in FIG. 7a, a plurality of heat slugs 152 is attached to the back surfaces 114 of a plurality of microelectronic dice 102, preferably with a thermally conductive adhesive (not shown). The back surfaces 156 of a plurality of heats slugs 152 are aligned on and attached to a first protective film 182, preferably an adhesive backed foil, which extends between a rigid frame 162, preferably a metal frame. The alignment may be achieved with fiducial marks (not shown) on the first protective film 182. As shown in FIG. 7b, a second protective film 184, such as a non-adhesive material, is mounted to a flat plate 166, such as an internal surface of a mold. The second protective film 184 is then pressed against the active surfaces 106 of a plurality of microelectronic dice 102. The encapsulation material 112 is molded around the microelectronic dice 102, as shown in FIG. 7c. After encapsulation, as shown in FIG. 7d; the first protective film 182 is removed and the removal of the flat plate 166 also removes the second protective film 184 to expose the active surfaces 106 of the plurality of microelectronic dice 102. As illustrated in FIG. 7e, at least one dielectric layer (shown as a first dielectric layer 118 and a second dielectric layer 126), conductive traces 124 and 132, and landing pads 134 are fabricated, such as described in FIG. 1c-1i.

## Claims

1. A microelectronic package, comprising:
a plurality of microelectronic dice (102), each said microelectronic die (102) having an active surface (106), at least one side (116) and a back surface (114);
encapsulation material (112) adjacent said microelectronic die sides (116), wherein said encapsulation material (112) includes a surface (110) coplanar with said microelectronic die active surfaces (106);
a first dielectric material layer (118) disposed on said microelectronic die active surfaces (106) and said encapsulation material surface (110);
at least one first conductive trace (124) disposed on said first dielectric material layer (118) and in electrical contact with said microelectronic die active surfaces (106), wherein said at least one first conductive trace (124) extends adjacent said microelectronic die active surfaces (106) and adjacent said encapsulation material surface (110); and
a heat dissipation device (164) in thermal contact with said microelectronic die back surfaces (114), wherein said heat dissipation device (164) comprises a webbed configuration in thermal contact with said microelectronic dice (102).

2. The microelectronic package of claim 1, further including a second dielectric material layer (126) disposed over said at least one first conductive trace (124) and said first dielectric material layer (118).

3. The microelectronic package of claim 2, including at least one second conductive trace (132), wherein at least a portion of said at least one second conductive trace (132) extends through and resides on said second dielectric material layer (126).

4. A method of fabricating a microelectronic package, comprising:
providing a plurality of microelectronic dice (102), each said microelectronic die (102) having an active surface (106), at least one side (116), and a back surface (114);
abutting a protective film (104) against said microelectronic die active surfaces (106);
providing a heat dissipation device (164) in thermal contact with said microelectronic die back surfaces (114), wherein said heat dissipation device (164) comprises a webbed configuration in thermal contact with said microelectronic dice (102);
encapsulating said microelectronic dice (102) with an encapsulation material (112) adjacent said microelectronic die sides (116), wherein said encapsulating material (112) provides a surface (110) of said encapsulation material coplanar with each said microelectronic die active surface (106);
removing said protective film (104);
forming a dielectric material layer (118) on said microelectronic die active surfaces (106) and said encapsulation material surface (110) ;
forming at least one via (122) through said dielectric material layer (118) to expose a portion of each of said microelectronic die active surfaces (106); and
forming at least one conductive trace (124) on said dielectric material layer (118) which extends into said at least one via (122) to electrically contact said portions of said microelectronic die active surfaces (106), wherein said at least one conductive trace (124) extends adjacent said microelectronic die active surfaces (106) and adjacent said encapsulation material surface (110).

5. The method of claim 4, further including forming an additional dielectric material layer (126) disposed over said at least one conductive trace (124) and said dielectric material layer (118).

6. The method of claim 5, including forming at least one second via (128) through said additional dielectric material layer (118), and forming at least one additional conductive trace (132) on said at least one additional dielectric material layer (126) which extends into said at least one additional via (128) to electrically contact respective ones of said at least one conductive trace (124).

7. The method of any one of claims 4 to 6, wherein the protective film (104) is an adhesive protective film.

8. The method of any one of claims 4 to 7, further including thinning said at least one microelectronic die (102) prior to providing said heat dissipation device (164) in thermal contact with said at least one microelectronic die back surface (114).

9. A method of fabricating a microelectronic package, comprising:
providing an adhesive protective film (182) suspended on a rigid frame (162);
attaching a back surface (114) of a plurality of microelectronic dice (102) to a heat dissipation device (164), wherein said heat dissipation device (164) comprises a webbed configuration in thermal contact with said microelectronic dice (102);
attaching a back surface of said heat dissipation device (164) to said adhesive film (182);
abutting a protective film (184) against an active surface (106) of each of said microelectronic dice (102);
encapsulating said microelectronic dice (102) with an encapsulation material (112) adjacent at least one side (116) of each of said microelectronic dice (102), wherein said encapsulating material (112) provides a surface (110) of said encapsulation material (112) substantially coplanar to said microelectronic die active surfaces (106);
removing said protective film (184); and
removing said adhesive protective film (182).

## Patentansprüche

1. Mikroelektronikbaugruppe, die aufweist:
eine Vielzahl von Mikroelektronikrohchips (102), wobei jeder Mikroelektronikrohchip (102) eine aktive Fläche (106), mindestens eine Seite (116) und eine hintere Fläche (114) aufweist;
ein Verkapselungsmaterial (112) benachbart den Seiten (116) des Mikroelektronikrohchips, wobei das Verkapselungsmaterial (112) eine Fläche (110) koplanar mit den aktiven Flächen (106) der Mikroelektronikrohchips umfasst;
eine erste dielektrische Materialschicht (118), die auf den aktiven Flächen (106) der Mikroelektronikrohchips und der Verkapselungsmaterialfläche (110) angeordnet ist;
mindestens eine erste Leiterbahn (124), die auf der ersten dielektrischen Materialschicht (118) und in elektrischem Kontakt mit den aktiven Flächen (106) der Mikroelektronikrohchips angeordnet ist, wobei sich die mindestens eine erste Leiterbahn (124) benachbart den aktiven Flächen (106) der Mikroelektronikrohchips und benachbart der Verkapselungsmaterialfläche (110) erstreckt; und
ein Wärmeableitungsbauelement (164) in Wärmekontakt mit den hinteren Flächen (114) der Mikroelektronikrohchips, wobei das Wärmeableitungsbauelement (164) eine mit Stegen versehene Konfiguration in Wärmekontakt mit dem Mikroelektronikrohchip (102) aufweist.

2. Mikroelektronikbaugruppe nach Anspruch 1, die außerdem eine zweite dielektrische Materialschicht (126) umfasst, die über der mindestens einen ersten Leiterbahn (124) und der ersten dielektrischen Materialschicht (118) angeordnet ist.

3. Mikroelektronikbaugruppe nach Anspruch 2, die mindestens eine zweite Leiterbahn (132) umfasst, wobei sich mindestens ein Teil der mindestens einen zweiten Leiterbahn (132) durch die zweite dielektrische Materialschicht (126) erstreckt und auf dieser liegt.

4. Verfahren zur Herstellung einer Mikroelektronikbaugruppe, das die folgenden Schritte aufweist:
Bereitstellen einer Vielzahl von Mikroelektronikrohchips (102), wobei jeder Mikroelektronikrohchip (102) eine aktive Fläche (106), mindestens eine Seite (116) und eine hintere Fläche (114) aufweist;
Anstoßen eines Schutzfilmes (104) an die aktiven Flächen (106) der Mikroelektronikrohchips;
Bereitstellen eines Wärmeableitungsbauelementes (164) in Wärmekontakt mit den hinteren Flächen (114) der Mikroelektronikrohchips, wobei das Wärmeableitungsbauelement (164) eine mit Stegen versehene Konfiguration in Wärmekontakt mit dem Mikroelektronikrohchip (102) aufweist;
Verkapseln des Mikroelektronikrohchips (102) mit einem Verkapselungsmaterial (112) benachbart den Seiten (116) des Mikroelektronikrohchips, wobei das Verkapselungsmaterial (112) eine Fläche (110) des Verkapselungsmaterials koplanar mit jeder aktiven Fläche (106) der Mikroelektronikrohchips bereitstellt;
Entfernen des Schutzfilmes (104);
Bilden einer dielektrischen Materialschicht (118) auf den aktiven Flächen (106) der Mikroelektronikrohchips und der Verkapselungsmaterialfläche (110);
Bilden von mindestens einem Kontaktloch (122) durch die dielektrische Materialschicht (118), um einen Teil einer jeden der aktiven Flächen (106) der Mikroelektronikrohchips freizulegen; und
Bilden mindestens einer Leiterbahn (124) auf der dielektrischen Materialschicht (118), die sich in das mindestens eine Kontaktloch (122) erstreckt, um die Teile der aktiven Flächen (106) der Mikroelektronikrohchips elektrisch zu kontaktieren, wobei sich die mindestens eine Leiterbahn (124) benachbart zu den aktiven Flächen (106) der Mikroelektronikrohchips und benachbart der Verkapselungsmaterialfläche (110) erstreckt.

5. Verfahren nach Anspruch 4, das außerdem den Schritt des Bildens einer zusätzlichen dielektrischen Materialschicht (126) umfasst, die über der mindestens einen Leiterbahn (124) und der dielektrischen Materialschicht (118) angeordnet ist.

6. Verfahren nach Anspruch 5, das den Schritt des Bildens von mindestens einem zweiten Kontaktloch (128) durch die zusätzliche dielektrische Materialschicht (118) und des Bildens von mindestens einer zusätzlichen Leiterbahn (132) auf der mindestens einen zusätzlichen dielektrischen Materialschicht (126) umfasst, die sich in das mindestens eine zusätzliche Kontaktloch (128) erstreckt, um die jeweiligen der mindestens einen Leiterbahn (124) elektrisch zu kontaktieren.

7. Verfahren nach einem der Ansprüche 4 bis 6, bei dem der Schutzfilm (104) ein adhäsiver Schutzfilm ist.

8. Verfahren nach einem der Ansprüche 4 bis 7, das außerdem den Schritt des Dünnermachens des mindestens einen Mikroelektronikrohchips (102) vor dem Bereitstellen des Wärmeableitungsbauelementes (164) in Wärmekontakt mit der mindestens einen hinteren Fläche (114) des Mikroelektronikrohchips umfasst.

9. Verfahren zum Herstellen einer Mikroelektronikbaugruppe, das die folgenden Schritte aufweist:
Bereitstellen eines adhäsiven Schutzfilmes (182), der an einem starren Rahmen (162) hängt;
Befestigen einer hinteren Fläche (114) einer Vielzahl von Mikroelektronikrohchips (102) an einem Wärmeableitungsbauelement (164), wobei das Wärmeableitungsbauelement (164) eine mit Stegen versehene Konfiguration in Wärmekontakt mit dem Mikroelektronikrohchip (102) aufweist;
Befestigen einer hinteren Fläche des Wärmeableitungsbauelementes (164) am adhäsiven Film (182);
Anstoßen eines Schutzfilmes (184) an eine aktive Fläche (106) eines jeden der Mikroelektronikrohchips (102);
Verkapseln des Mikroelektronikrohchips (102) mit einem Verkapselungsmaterial (112) benachbart mindestens einer Seite (116) eines jeden der Mikroelektronikrohchips (102), wobei das Verkapselungsmaterial (112) eine Fläche (110) des Verkapselungsmaterials (112) im Wesentlichen koplanar mit den aktiven Flächen (106) der Mikroelektronikrohchips bereitstellt;
Entfernen des Schutzfilmes (184); und
Entfernen des adhäsiven Schutzfilmes (182).

## Revendications

1. Boîtier microélectronique comprenant:
une pluralité de matrices microélectroniques (102), chaque dite matrice microélectronique (102) ayant une surface active (106), au moins un côté (116) et une surface postérieure (114);
un matériau d'encapsulation (112) adjacent audits côtés (116) de la matrice microélectronique, dans lequel ledit matériau d'encapsulation (112) inclut une surface (110) coplanaire avec lesdites surfaces actives (106) de la matrice microélectronique;
une première couche de matériau diélectrique (118) disposée sur lesdites surfaces actives (106) de la matrice microélectronique et ladite surface (110) du matériau d'encapsulation;
au moins un premier ruban conducteur (124) disposé sur ladite première couche de matériau diélectrique (118) et en contact électrique avec lesdites surfaces actives (106) de la matrice microélectronique, dans lequel ledit au moins un premier ruban conducteur (124) s'étend de manière adjacente aux dites surfaces actives (106) de la matrice microélectronique et adjacente à ladite surface (110) du matériau d'encapsulation; et
un dispositif de dissipation thermique (164) en contact thermique avec lesdites surfaces postérieures (114) de la matrice microélectronique, dans lequel ledit dispositif de dissipation thermique (164) comprend une configuration réticulée en contact thermique avec lesdites matrices microélectroniques (102).

2. Boîtier microélectronique selon la revendication 1, incluant, en outre, une seconde couche de matériau diélectrique (126) disposée sur ledit au moins un premier ruban conducteur (124) et ladite première couche de matériau diélectrique (118).

3. Boîtier microélectronique selon la revendication 2, incluant au moins un second ruban conducteur (132), dans lequel au moins une partie dudit au moins un second ruban conducteur (132) s'étend à travers ladite seconde couche de matériau diélectrique (126) et est présente sur celle-ci.

4. Procédé de fabrication d'un boîtier microélectronique, comprenant:
la fourniture d'une pluralité de matrices microélectroniques (102), chaque dite matrice microélectronique (102) ayant une surface active (106), au moins un côté (116) et une surface postérieure (114);
l'aboutement d'un film protecteur (104) contre lesdites surfaces actives (106) de la matrice microélectronique;
la fourniture d'un dispositif de dissipation thermique (164) en contact thermique avec lesdites surfaces postérieures (114) de la matrice microélectronique, dans lequel ledit dispositif de dissipation thermique (164) comprend une configuration réticulée en contact thermique avec lesdites matrices microélectroniques (102);
l'encapsulation desdites matrices microélectroniques (102) avec un matériau d'encapsulation (112) adjacent audits côtés (116) de la matrice microélectronique, dans lequel ledit matériau d'encapsulation (112) fournit une surface (110) dudit matériau d'encapsulation coplanaire avec chaque dite surface active (106) de la matrice microélectronique;
le retrait dudit film protecteur (104);
la formation d'une couche de matériau diélectrique (118) sur lesdites surfaces actives (106) de la matrice microélectronique et ladite surface (110) du matériau d'encapsulation;
la formation d'au moins un trou d'interconnexion (122) à travers ladite couche de matériau diélectrique (118) pour exposer une partie de chacune desdites surfaces actives (106) de la matrice microélectronique; et
la formation d'au moins un ruban conducteur (124) sur ladite couche de matériau diélectrique (118) qui s'étend dans ledit au moins un trou d'interconnexion (122) pour entrer en contact électrique avec lesdites parties desdites surfaces actives (106) de la matrice microélectronique, dans lequel ledit au moins un ruban conducteur (124) s'étend de manière adjacente aux dites surfaces actives (106) de la matrice microélectronique et adjacente à ladite surface (110) du matériau d'encapsulation.

5. Procédé selon la revendication 4, incluant, en outre, la formation d'une couche supplémentaire de matériau diélectrique (126) disposée sur ledit au moins un ruban conducteur (124) et ladite couche de matériau diélectrique (118).

6. Procédé selon la revendication 5, incluant la formation d'au moins un second trou d'interconnexion (128) à travers ladite couche supplémentaire de matériau diélectrique (118) et la formation d'au moins un ruban conducteur supplémentaire (132) sur ladite au moins une couche supplémentaire de matériau diélectrique (126) qui s'étend dans ledit au moins un trou d'interconnexion supplémentaire (128) pour établir un contact électrique avec des rubans respectifs dudit au moins un ruban conducteur (124).

7. Procédé selon l'une quelconque des revendications 4 à 6, dans lequel le film protecteur (104) est un film protecteur adhésif.

8. Procédé selon l'une quelconque des revendications 4 à 7, incluant, en outre, un amincissement de ladite au moins une matrice microélectronique (102) avant d'amener ledit dispositif de dissipation thermique (164) en contact thermique avec ladite au moins une surface postérieure (114) de la matrice microélectronique (114).

9. Procédé de fabrication d'un boîtier microélectronique, comprenant:
la fourniture d'un film protecteur adhésif (182) suspendu sur un cadre rigide (162);
la fixation d'une surface postérieure (114) d'une pluralité de matrices microélectroniques (102) sur un dispositif de dissipation thermique (164), dans lequel ledit dispositif de dissipation thermique (164) comprend une configuration en toile en contact thermique avec lesdites matrices microélectroniques (102);
l'attachement d'une surface postérieure dudit dispositif de dissipation thermique (164) audit film adhésif (182);
l'aboutement d'un film protecteur (184) contre une surface active (106) de chacune desdites matrices microélectroniques (102);
l'encapsulation desdites matrices microélectroniques (102) avec un matériau d'encapsulation (112) adjacent à au moins un côté (116) de chacune desdites matrices microélectroniques (102), dans lequel ledit matériau d'encapsulation (112) fournit une surface (110) dudit matériau d'encapsulation (112) essentiellement coplanaire avec lesdites surfaces actives (106) de la matrice microélectronique;
le retrait dudit film protecteur (184); et
le retrait dudit film protecteur adhésif (182).
